# EUROPÄISCHE PATENTSCHRIFT

(11) **EP 1 624 086 B1**
(45) Veröffentlichungstag und Bekanntmachung des Hinweises auf die Patenterteilung: **08.02.2012**
(21) Anmeldenummer: 04018645.4
(22) Anmeldetag: 06.08.2004
(51) Int. Cl.: C23C 14/00, C23C 14/02, C23C 14/06, H01J 37/32

(54) **Vorrichtung und Verfahren für die Herstellung von gasundurchlässigen Schichten**
Device and method for producing gas barrier layers
Dispositif et méthode pour la fabrication de couches imperméables aux gaz

(43) Veröffentlichungstag der Anmeldung: 08.02.2006
(73) Patentinhaber: Applied Materials GmbH & Co. KG, 63755 Alzenau (DE)
(72) Erfinder: Hegemann, Thomas, 63579 Freigericht (DE); Sommer, Elisabeth, 63755 Alzenau (DE)
(74) Vertreter: Schickedanz, Willi

(56) Entgegenhaltungen:
- EP-A- 0 394 658
- EP-A- 0 787 821
- WO-A-91/17283
- WO-A-2004/042107
- WO-A-2004/042111
- DE-A- 3 642 161
- GB-A- 2 276 634
- US-A- 5 464 683
- US-A1- 2003 091 871
- R.G. JOHANSON, W.G. CARRUTHERS: "Practical in-line reactive sputtering" J. VAC. SCI. TECHNOL. A, Bd. 5, Nr. 4, 1987, Seiten 2246-2252, XP009042540 USA
- SCHULTE J ET AL: "Magnetron sputtering of aluminium using oxygen or nitrogen as reactive gas" PREPARATION AND CHARACTERIZATION, ELSEVIER SEQUOIA, NL, Bd. 324, Nr. 1-2, 1. Juli 1998 (1998-07-01), Seiten 19-24, XP004147795 ISSN: 0040-6090
- DREER S ET AL: "Statistical evaluation of refractive index, growth rate, hardness and Young's modulus of aluminium oxynitride films" PREPARATION AND CHARACTERIZATION, ELSEVIER SEQUOIA, NL, Bd. 354, Nr. 1-2, 8. Oktober 1999 (1999-10-08), Seiten 43-49, XP004321387 ISSN: 0040-6090

## Beschreibung

Die Erfindung betrifft eine Vorrichtung und ein Verfahren für die Herstellung einer transparenten, gasundurchlässigen Beschichtung nach den Oberbegriffen der Patentansprüche 1 und 9.

Kunststoffbehälter sind in der Regel nicht ganz gasdicht, was sich bei Gasen enthaltenden Getränkebehältern - z. B. Kohlensäure enthaltenden Limonade- oder Bierdosen - insofern negativ bemerkbar macht, als die Kohlensäure aus dem Behälter allmählich durch Diffusion entweicht, weil die Kohlendioxidkonzentration im Behälter größer als außerhalb des Behälters ist. Würde man beispielsweise eine PET-Flasche (PET = Polyethylenterephthalat) ausschließlich mit Kohlendioxid füllen, so käme der Diffusionsprozess erst dann zum Erliegen, wenn das Gasgemisch innerhalb und außerhalb der Flasche dieselbe Konzentration erreicht hat. Da nicht nur Kohlendioxid entweicht, sondern auch Sauerstoff und Stickstoff in die Flasche hinein diffundieren, wird nach genügend langer Zeit die Flasche mit demselben Gasgemisch gefüllt sein, wie es die Umgebungsluft hat. Wäre die Flasche mit CO₂-Überdruck gefüllt, würde sie am Ende dieses Prozesses einen Unterdruck aufweisen, und der äußere Luftdruck würde die Flasche zusammendrücken. Um das Entweichen von Kohlensäure oder Wasserdampf und das Eindringen von Sauerstoff zu verhindern, werden die Kunststoffflaschen mit einer Gasbarriere versehen.

Diese Gasbarneren haben indessen den Nachteil, dass sie meist reißen, wenn sich der so beschichtete Behälter ausdehnt oder wenn er schrumpft.

Es ist bereits ein Schichtsystem für Kunststoffkörper bekannt, das eine direkt auf dem Kunststoffkörper aufgebrachte Akrylatschicht aufweist, auf der sich eine Schicht aus gasundurchlässigem Material befindet, die ihrerseits eine Akrylatschicht trägt (US 6 231 939). Durch die Verwendung zweier Akrylatschichten, in die das gasundurchlässige Material eingebettet ist, erlangt die Gesamtbeschichtung eine gewisse Elastizität. Als gasdurchlässiges Metall wird dabei Siliziumoxid, Aluminiumoxid oder Metall verwendet.

Nachteilig ist hierbei jedoch, dass die gasundurchlässige Schicht relativ dick ist und damit - wenn sie aus Metall besteht - undurchsichtig und relativ unelastisch ist.

Der Erfindung liegt die Aufgabe zugrunde, eine transparente und gasdichte Beschichtung mittels einer Sputtervorrichtung auf einem Kunststoffsubstrat aufzubringen und mit der gleichen Sputtervorrichtung eine reflektierende Barriereschicht herzustellen.
Diese Aufgabe wird gemäß den Merkmalen der Patentansprüche 1 und 9 gelöst.

Die Erfindung betrifft somit eine Vorrichtung und ein Verfahren für die Herstellung von gasundurchlässigen Schichten, insbesondere für die Beschichtung von gasdurchlässigen Kunststoffsubstraten. Mit Hilfe dieser Vorrichtung bzw. dieses Verfahrens ist es möglich, mit nur einer Sputteranlage sowohl lichtdurchlässige als auch lichtundurchlässige gassperrende Schichten herzustellen. Hierbei wird lediglich von einer Gaszuführung, z. B. Argon, auf eine zweite Gaszuführung aus Argon, Sauerstoff und Stickstoff bzw. umgekehrt umgeschaltet.

Der mit der Erfindung erzielte Vorteil besteht insbesondere darin, dass durch die Verwendung von Aluminium als Sputtermaterial sowohl eine klarsichtige als auch eine undurchsichtige Sperrschicht mit der gleichen Sputteranlage erzeugt werden kann. Außerdem ermöglicht die Verwendung von Aluminiumoxinitrid als Sperrschicht ein Recyceln der beschichteten Substrate. Des Weiteren überstehen die beschichteten Substrate einen Pasteurisierungsprozess. Zudem ist die Beschichtung elastisch, um sowohl den Schrumpfungsprozess bei einer Heißabfüllung von PET-Flaschen als auch die Ausdehnung von unter Druck stehenden Flaschen auszuhalten, ohne dass sich Risse bilden.

Ein Ausführungsbeispiel der Erfindung ist in den Zeichnungen dargestellt und wird im Folgenden näher beschrieben. Es zeigen:
- Fig. 1: eine erfindungsgemäße Beschichtung auf einem Substrat;
- Fig. 2: eine Kunststoffflasche mit einer Außenbeschichtung;
- Fig. 3: eine Sputteranlage für die Beschichtung von Kunststoffflaschen.

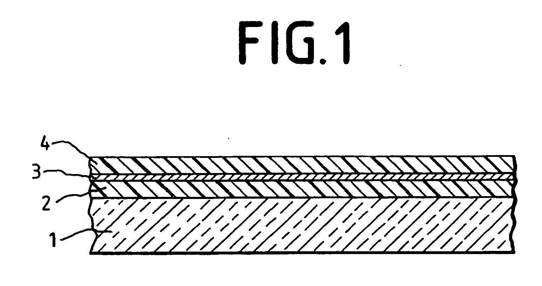

Die Fig. 1 zeigt einen Ausschnitt aus einem Substrat 1, das mit einer Beschichtung versehen ist. Bei dem Substrat 1 handelt es sich beispielsweise um einen Teil einer Wandung einer PET-Flasche. Auf diesem Substrat 1 befindet sich eine 0,2 bis 1,5 µm dicke Polymerschicht 2, beispielsweise eine Acrylatschicht, auf der sich eine 1 bis 100 nm dicke Aluminiumoxinitrid-Schicht 3 befindet. Über dieser AlOₓN_{y}-Schicht 3 ist eine weitere Polymerschicht 4 von 0,2 bis 1,5 µm Dicke aufgebracht, die ebenfalls ein Acrylat sein kann.

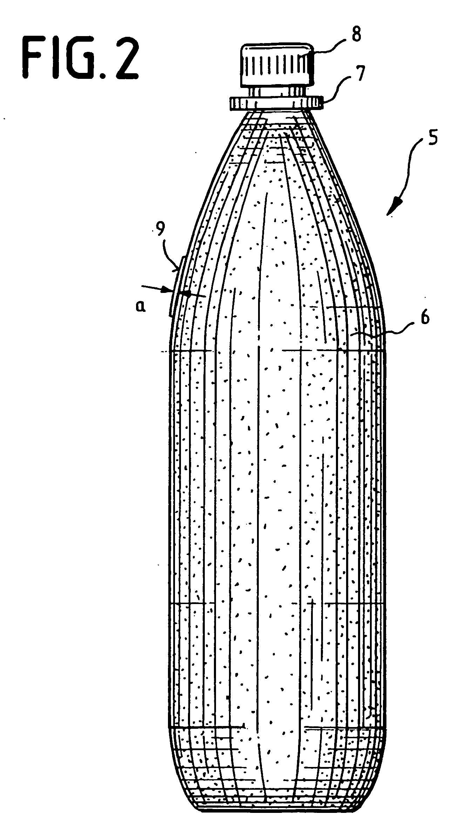

In der Fig. 2 ist eine Kunststoffflasche 5 dargestellt, die aus einem Aufnahmebehälter 6 für ein Getränk, einem Kragen 7 und einem Verschluss 8 besteht. Der Aufnahmebehälter 6 und der Kragen 7 bestehen beispielsweise aus PET und sind klarsichtig. Um diese klarsichtige Kunststoffflasche 1 gegen Gasdiffusion sicher zu machen, wird über den ganzen Aufnahmebehälter 6 oder über Teile dieses Aufnahmebehälters 6 eine Beschichtung 9 aufgebracht, die in Fig. 1 auf der Außenseite des Aufnahmebehälters 6 lediglich angedeutet ist. Diese Beschichtung hat eine Dicke a, welche die Summe der Dicken der Schicht 2, 3, 4 darstellt.

Es wird angestrebt, die Beschichtung 9 je nach Wahl durchsichtig oder undurchsichtig zu machen. Durchsichtig ist eine Schicht aus AlOₓN_{y}, während eine Schicht aus Al undurchsichtig ist.

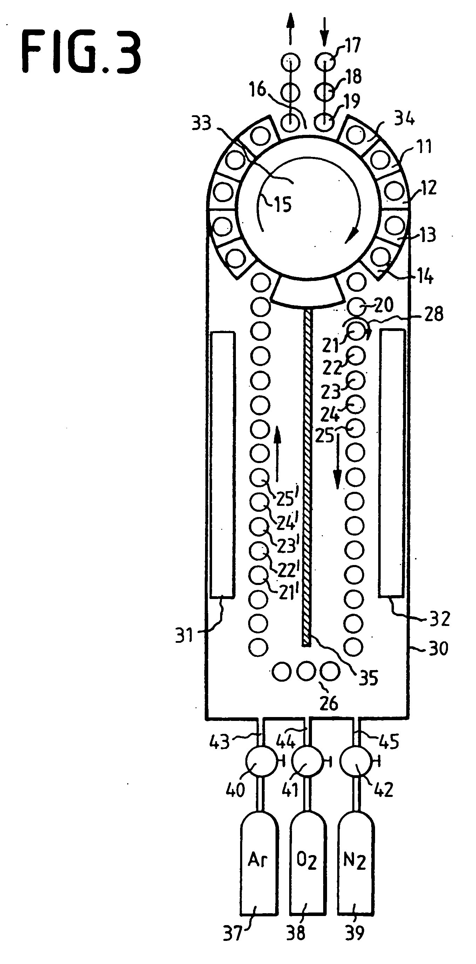

Die Fig. 3 zeigt schematisch eine Anlage zum Beschichten von Kunststoffflaschen wahlweise mit Aluminiumoxinitrid oder mit Aluminium als Sperrschicht. Eine Vakuum-Beschichtungskammer 30 enthält hierbei auf zwei Seiten jeweils wenigstens eine Magnetronkathode 31, 32. Statt einer Kathode können auf jeder Seite auch mehrere Kathoden hintereinander angeordnet sein. Die Kathoden sind mit einem Aluminiumtarget bestückt. Zwischen den Kathoden 31, 32 kann auch noch eine Trennwand 35 vorgesehen sein. Am Eingang zur Vakuum-Beschichtungskammer 30 befindet sich eine Schleusenkammer 33, die auf einem Kreisring mehrere Aufnahmekammern 34, 36, 11 bis 14 aufweist. Diese Schleusenkammer 33 dreht sich im Uhrzeigersinn, was durch den Pfeil 15 angedeutet ist. Am Eingang 16 der Schleusenkammer 33 herrscht Atmosphärendruck. Es werden dort nicht beschichtete Kunststoffflaschen 17, 18, 19 auf eine nicht dargestellte lineare Fördereinrichtung gestellt, die dann in eine kreisringförmige Fördereinrichtung übergeht. Hierdurch werden die Flaschen, die sich auf der Fördereinrichtung befinden, von der Atmosphäre in das Hochvakuum der Beschichtungskammer 30 gebracht. Dort gelangen die Flaschen, von denen einige mit Bezugszahlen 21 bis 25 versehen sind, unter Drehung um ihre Längsachse, was durch den Pfeil 28 angedeutet ist, wieder auf eine nicht dargestellte lineare Fördereinrichtung, mit deren Hilfe sie an der Magnetronkathode 32 bzw. an einer Reihe von Magnetronkathoden vorbeigeführt werden. Von den Aluminium-Targets dieser Magnetronkathoden werden Metallpartikel abgesputtert, die dann mit Sauerstoff und Stickstoff reagieren. Hierdurch schlägt sich auf der Außenwand der Flaschen Aluminiumoxinitrid nieder. Die Flaschen in der Vakuum-Beschichtungskammer 30 drehen sich alle ständig um die eigene Längsachse, und zwar mindestens so schnell, dass eine 360°-Drehung erreicht wird, bevor die Flasche eine Magnetronkathode 32 passiert hat. Eine gleichmäßigere Verteilung der Beschichtung erhält man, wenn die Rotation der Flasche ein Mehrfaches annimmt. Am Ende 26 der rechtsseitigen Beschichtungsstrecke machen die sich drehenden Flaschen eine Kehrtwendung von 180 Grad und werden nun mit Hilfe der Magnetronkathode 31 mit Aluminiumoxinitrid beschichtet. Die neuen Positionen der Flaschen sind mit 21' bis 25' bezeichnet.

Die Räume zwischen der Trennwand 35 und den Magnetronkathoden 31, 32 können als Vakuum-Sputterkammern angesehen werden. Wenigstens eine dieser Kammern weist drei Gaszuführungen auf, durch die neben Argon auch Sauerstoff und Stickstoff eingelassen werden können.

In der Fig. 3 sind drei Gasflaschen 37, 38, 39 mit Sperrventilen 40, 41, 42 dargestellt, die über Zuführungen 43, 44, 45 mit den Sputterräumen in Verbindung stehen. Werden die Zuführungen 44, 45 von Sauerstoff und Stickstoff gesperrt, schlägt sich reines Aluminium auf den Flaschen nieder. Dieses reine Aluminium spiegelt wie Silber, wenn es am Oxidieren gehindert wird. Sind alle Ventile 40 bis 42 geöffnet, bildet sich AlOₓN_{y} und schlägt sich auf den Flaschen nieder. Statt der Gasflaschen 38, 39 kann auch nur eine Flasche vorgesehen sein, die Luft enthält. Luft enthält 78,084 % N₂ und 20,946 % O₂.

Bevor die Flaschen in die Vakuum-Sputterkammern gebracht werden, werden sie mit einer Acrylatschicht versehen. Auch nach der Beschichtung mit der gasundurchlässigen Schicht Al oder AlOₓN_{y} wird eine weitere Acrylatschicht aufgebracht. Die Anlage, in welcher die Acrylatschichten aufgebracht werden, ist nicht dargestellt.

Indem Aluminium als Sputtermaterial dient, können mit derselben Beschichtungseinrichtung dekorativ-metallische sowie transparente Barriereschichten hergestellt werden, und zwar ohne Umrüstzeiten. Dabei kann sowohl die lichtdurchlässige als auch die lichtundurchlässige Schicht mittels preiswertem DC-Sputtern erzeugt werden.

Schon ca. 4 nm dicke AlOₓN_{y}-Schichten reichen aus, um die notwendigen Barriereeigenschaften zu erzielen. Solch dünne Schichten können extrem unterstöchiometrisch gefahren werden, ohne die notwendigen Transparenz- und Barriereeigenschaften zu verlieren. Vorzugsweise erfüllen hierbei x und y die Bedingungen 0 < x < 0,6 bzw. 0 < y < 0,5, was sich durch entsprechende Einstellung der Sputterparameter erreichen lässt.

Die gleichen Schichten - Al und AlOₓN_{y} - können statt mit dem einfachen DC-Sputtern auch mit der technisch aufwändigeren MF/RF-Sputtertechnologie hergestellt werden, was jedoch die Beschichtungskosten deutlich erhöhen würde.

Um diese Schichten zu erhalten, wurden unter Laborbedingungen folgende Sputterparameter gewählt: Als Gasflüsse 16 Standardkubikzentimeter Luft und 110 Standardkubikzentimeter Argon bei einem Druck von 4 x 10⁻³ mbar. Bei einer elektrischen Leistung von 500 W wurde eine Kunststoffflasche beschichtet, wobei sich die Flasche um ihre Längsachse drehte, aber nicht an der Kathode vorbeibewegt wurde.

Es wurde nur der Luft-Gasfluss zwischen 13 und 19 Standardkubikzentimeter variiert. Die Zusammensetzung der Luft blieb dabei unverändert. Der Argongasfluss wurde zwischen 80 und 140 Standardkubikzentimeter eingestellt und die Beschichtungszeit zwischen 3 und 7 Sekunden gewählt. Die aufgestäubten Schichtdicken betrugen zwischen zwei und neun Nanometer, wobei sich herausstellte, dass mindestens sechs bis sieben Nanometer Schichtdicke erforderlich sind, um BIF-Werte > 5 zu erzielen. Unter einem BIF-Wert (BIF = Barrier Improvement Factor) versteht man das Verhältnis der Durchlässigkeit eines Substrats mit Beschichtung zur Durchlässigkeit eines Substrats ohne Beschichtung.

Bei Produktionsanlagen, wie sie die Fig. 3 zeigt und die etwa 20.000 Flaschen pro Stunde beschichten sollen, wird die Beschichtungszeit auf ca. 5,55 Sekunden reduziert. Dazu kann die Sputterleistung auf 630 W erhöht werden, sodass das Produkt aus Beschichtungszeit und Kathodenleistung konstant bleibt und somit in erster Näherung dieselbe Schichtdicke abgeschieden wird. Da die Produktionsanlage im Gegensatz zur Laboranlage aber eine Durchlaufanlage ist, erfolgt die Beschichtung hier dynamisch, d. h. das Substrat wird an der Kathode 32, 31 vorbeibewegt und dabei gleichzeitig um seine Längsachse gedreht. Anstatt die Sputterleistung zu erhöhen, kann auch eine längere Kathode verwendet werden, sodass die Sputterleistung aus dem Laborversuch beibehalten werden kann und die Flaschen mit einer Transportgeschwindigkeit bewegt werden, die gewährleistet, dass alle 5,55 Sekunden eine Flasche aus der Anlage ausgeschleust wird.

Einen Einfluss auf die Aufwachsrate der Schicht hat auch der Abstand zwischen Sputterkathode 31, 32 und Substrat 21 - 25; 21' - 25'. Wenn dieser Abstand in der Produktionsanlage von dem der Laboranlage abweicht, muss die Leistung entsprechend angepasst werden: Bei größerem Abstand benötigt man eine höhere Leistung, bei kleinerem Abstand muss man sie reduzieren.

Das Verhältnis von Argon zu Luft ist bei der Produktionsanlage ähnlich wie in der Laboranlage, aber die genauen Gasflüsse hängen vom Anlagenleitwert und vom Saugvermögen ab. Der Anlagenleitwert hängt von dem inneren Aufbau ab, der in einer Produktionsanlage durch andere Anforderungen bestimmt wird als in einer Laboranlage.

Die Beschichtung wurde vorstehend im Zusammenhang mit der Beschichtung von Flaschen beschrieben. Es versteht sich jedoch, dass auf die gleiche Weise auch Folien und anderes Bandmaterial beschichtet werden können. Entsprechende Bandbeschichtungsanlagen sind bereits bekannt, vgl. EP-Anmeldung 04 012 165.9. Statt zweier Gasflaschen 38, 39 mit O₂ bzw. N₂ oder einer Flasche, die beide Gase enthält, kann auch direkt auf die Außenluft Zugriff genommen und auf die Flaschen 38, 39 ganz verzichtet werden. Der zweite Gasbehälter ist dann die Außenluft.

## Patentansprüche

1. Vorrichtung für die Herstellung einer gasundurchlasslgen Schicht (3) auf einem Kunststoffsubstrat (1), mit
- einer Vakuum-Sputterkammer (30),
- wenigstens einem Target (31, 32) aus Aluminium und
- wenigstens zwei Gasbehältern (37 - 39), die über wenigstens eine absperrbare Gaszuführungsleitung (43 - 45) mit der Vakuum-Sputterkammer (30) verbunden sind, wobei sich in einem dieser Gasbehälter (37) Argon befindet,
**gekennzeichnet durch** eine Umschalteinrichtung (40 - 42), mit der ein zweiter Gasbehälter (38, 39), der Stickstoff und Sauerstoff enthält, an die Vakuum-Sputterkammer (30) gelegt oder von dieser getrennt werden kann.

2. Vorrichtung nach Anspruch 1, **dadurch gekennzeichnet, dass** der zweite Gasbehälter (38 oder 39) Luft enthält.

3. Vorrichtung nach Anspruch 1, **dadurch gekennzeichnet, dass** drei Gasbehälter (37, 38, 39) vorgesehen sind, wobei der erste Gasbehälter (37) Argon, der zweite Gasbehälter (38) Sauerstoff und der dritte Gasbehälter (39) Stickstoff enthält.

4. Vorrichtung nach den Ansprüchen 1, 2 oder 3, **dadurch gekennzeichnet, dass** alle zwei bzw. drei Gaszuführungsleitungen (43 bis 45) geöffnet sind.

5. Vorrichtung nach den Ansprüchen 1, 2 oder 3, **dadurch gekennzeichnet, dass** nur die Gaszuführungsleitung (43) für Argon geöffnet ist

6. Vorrichtung nach Anspruch 1, **dadurch gekennzeichnet, dass** das Kunststoffsubstrat gasdurchlässig und ein Hohlkörper (5) ist.

7. Vorrichtung nach Anspruch 1, **dadurch gekennzeichnet, dass** die gasundurchlässige Schicht Aluminium ist.

8. Vorrichtung nach Anspruch 1, **dadurch gekennzeichnet, dass** die gasundurchlässige Schicht wenigstens eine Schicht AlOₓN_{y} enthält, wobei 0 < x < 0,6 und 0 < y < 0,5 sind.

9. Verfahren für die sukzessive Herstellung unterschiedlicher gasundurchlässiger Schichten auf einem gasdurchlässigen Substrat, **gekennzeichnet durch** folgende Schritte:
a) es wird in einem ersten Herstellungsprozess ein Aluminium-Target (31, 32) in einer Vakuum-Sputterkammer (30) bereitgestellt;
b) es wird Argon als Sputtergas in die Vakuum-Sputterkammer (30) eingeführt;
c) das Aluminium-Target (31, 32) wird gesputtert;
d) es werden in einem zweiten Herstellungsprozess neben Argon als Sputtergas auch noch Sauerstoff und Stickstoff als Reaktivgase in die Vakuum-Sputterkammer (30) eingeführt;
e) das Aluminium wird gesputtert.

10. Verfahren nach Anspruch 9, **dadurch gekennzeichnet, dass** als Reaktivgas Luft in die Vakuum-Sputterkammer (30) eingeführt wird.

11. Verfahren nach Anspruch 9, **dadurch gekennzeichnet, dass** die Betriebsparameter des Sputtervorgangs derart eingestellt werden, dass eine undurchsichtige Beschichtung aus Al entsteht.

12. Verfahren nach Anspruch 9, **dadurch gekennzeichnet, dass** die Betriebsparameter des Sputtervorgangs derart eingestellt werden, dass eine transparente, gasundurchlässige Beschichtung aus AlOₓN_{y} entsteht, wobei 0 < x < 0,6 und 0 < y < 0,5.

13. Verfahren nach Anspruch 12, **dadurch gekennzeichnet, dass** die AlOₓNy-Schicht 1 bis 100 nm dick ist.

14. Verfahren nach den Ansprüchen 12 oder 13, **dadurch gekennzeichnet, dass** die AlOₓN_{y}-Schicht zwischen Polymerschichten eingebettet wird.

15. Verfahren nach Anspruch 14, **dadurch gekennzeichnet, dass** die Polymerschichten Acrylatschichten von 0,2 bis 1,5 µm Dicke sind.

16. Verfahren nach Anspruch 9, **dadurch gekennzeichnet, dass** das Reaktivgas zu mehr als 50 % Stickstoff enthält.

17. Verfahren nach Anspruch 9, **dadurch gekennzeichnet, dass** das Reaktivgas ca. 65 % bis 90 % Stickstoff und ca. 10 % bis 35 % Sauerstoff enthält.

18. Verfahren nach Anspruch 14, **dadurch gekennzeichnet, dass** die Polymerschichten aus kationisch polymerisierendem Material der Dicke 0,2 bis 1,5 µm bestehen.

## Claims

1. Apparatus for the production of a gas-impermeable layer (3) on a synthetic material substrate (1), comprising:
- a vacuum sputtering chamber (30),
- at least one target (31, 32) comprising aluminum, and
- at least two gas containers (37 - 39), which are connected with the vacuum sputtering chamber (30) via at least one gas inlet line (43 - 45), which can be shut, whereby one of said gas containers (37) contains argon,
charcterized by a switch-over device (40 - 42) by means of which a second gas container (38, 39) comprising nitrogen and oxygen is connectable and disconnectable to said vacuum sputtering chamber (30).

2. Apparatus as claimed in claim 1, **characterized in that** the second gas container (38 or 39) contains air.

3. Apparatus as claimed in claim 1, **characterized in that** three gas containers (37, 38, 39) are provided, whereby the first gas container (37) contains argon, the second gas container (38) contains oxygen and the third gas container (39) contains nitrogen.

4. Apparatus as claimed in claims 1, 2 or 3, **characterized in that** all of the two or all of the three gas inlet lines (43 to 45) are opened.

5. Apparatus as claimed in claims 1, 2 or 3, **characterized in that** only the gas inlet line (43) for argon is opened.

6. Apparatus as claimed in claim 1, **characterized in that** the synthetic material substrate is gas-permeable and a hollow body (5).

7. Apparatus as claimed in claim 1, **characterized in that** the gas-impermeable layer is aluminum.

8. Apparatus as claimed in claim 1, wherein the gas-impermeable layer contains at least a layer of AlOₓN_{y}, in which 0 < x < 0.6 and 0 < y < 0.5.

9. Method for the successive production of different gas-impermeable layers on a gas-permeable substrate, comprising the steps of:
a) providing in a first production process a target (31, 32) comprising aluminum in a vacuum sputtering chamber (30);
b) introducing argon as a sputtering gas into the vacuum sputtering chamber (30);
c) sputtering the aluminum target (31, 32);
d) introducing in a second production process argon as a sputtering gas, oxygen and nitrogen as reactive gases into the vacuum sputtering chamber (30);
e) sputtering the aluminum.

10. Method as claimed in claim 9, **characterized in that** air is introduced as a reactive gas into the vacuum sputtering chamber (30).

11. Method as claimed in claim 9, **characterized in that** the operating parameters of the sputtering process are set such, that an opaque coating of Al is generated.

12. Method as claimed in claim 9, **characterized in that** the operating parameters of the sputtering process are set such, that a transparent, gas-impermeable coating of AlOₓN_{y} is generated, in which 0 < x < 0.6 and 0 < y < 0.5.

13. Method as claimed in claim 12, **characterized in that** the AlOₓN_{y} layer is 1 to 100 nm thick.

14. Method as claimed in claims 12 or 13, **characterized in that** the AlOₓN_{y} layer is embedded between polymer layers.

15. Method as claimed in claim 14, **characterized in that** the polymer layers are acrylate layers having a thickness of 0.2 to 1.5 µm.

16. Method as claimed in claim 9, **characterized in that** the reactive gas contains more than 50% nitrogen.

17. Method as claimed in claim 9, **characterized in that** the reactive gas contains approximately 65% to 90% nitrogen and approximately 10% to 35% oxygen.

18. Method as claimed in claim 14, **characterized in that** the polymer layers comprise cationically polymerizing material having a thickness of 0.2 to 1.5 µm.

## Revendications

1. Dispositif permettant de fabriquer une couche (3) imperméable au gaz sur un substrat de matière plastique (1), comprenant
- une chambre de pulvérisation cathodique sous vide (30),
- au moins une cible (31, 32) en aluminium et
- au moins deux réservoirs de gaz (37 - 39) qui sont reliés, par au moins une conduite d'amenée de gaz (43 - 45) pouvant être fermée, à la chambre de pulvérisation cathodique sous vide (30), un de ces réservoirs de gaz (37) contenant de l'argon,
**caractérisé par** un dispositif de commutation (40 - 42) avec lequel un deuxième réservoir de gaz (38, 39) qui contient de l'azote et de l'oxygène peut être relié à la chambre de pulvérisation cathodique sous vide (30) ou être séparé de celle-ci.

2. Dispositif selon la revendication 1, **caractérisé en ce que** le deuxième réservoir de gaz (38 ou 39) contient de l'air.

3. Dispositif selon la revendication 1, **caractérisé en ce qu'**il est prévu trois réservoirs de gaz (37, 38, 39), le premier réservoir de gaz (37) contenant de l'argon, le deuxième réservoir de gaz (38) contenant de l'oxygène et le troisième réservoir de gaz (39) contenant de l'azote.

4. Dispositif selon la revendication 1, 2 ou 3, **caractérisé en ce que** toutes les deux ou toutes les trois conduites d'amenée de gaz (43 à 45) sont ouvertes.

5. Dispositif selon la revendication 1, 2 ou 3, **caractérisé en ce que** seule la conduite d'amenée de gaz (43) pour l'argon est ouverte.

6. Dispositif selon la revendication 1, **caractérisé en ce que** le substrat de matière plastique est perméable au gaz et est un corps creux (5).

7. Dispositif selon la revendication 1, **caractérisé en ce que** la couche imperméable au gaz est de l'aluminium.

8. Dispositif selon la revendication 1, **caractérisé en ce que** la couche imperméable au gaz contient au moins une couche de AlOₓN_{y}, sachant que 0 < x < 0,6 et 0 < y < 0,5.

9. Procédé permettant la fabrication successive de différentes couches imperméables au gaz sur un substrat perméable au gaz, **caractérisé par** les étapes suivantes:
a) dans un premier processus de fabrication, une cible en aluminium (31, 32) est placée dans une chambre de pulvérisation cathodique sous vide (30);
b) de l'argon est introduit comme gaz de pulvérisation cathodique dans la chambre de pulvérisation cathodique sous vide (30);
c) la cible en aluminium (31, 32) est soumise à une pulvérisation cathodique;
d) dans un deuxième processus de fabrication, de l'oxygène et de l'azote sont introduits, comme gaz réactifs, en plus de l'argon, comme gaz de pulvérisation cathodique, dans la chambre de pulvérisation cathodique sous vide (30);
e) l'aluminium est soumis à une pulvérisation cathodique.

10. Procédé selon la revendication 9, **caractérisé en ce que** de l'air est introduit comme gaz réactif dans la chambre de pulvérisation cathodique sous vide (30).

11. Procédé selon la revendication 9, **caractérisé en ce que** les paramètres de fonctionnement du processus de pulvérisation cathodique sont réglés de telle sorte qu'il se forme un revêtement opaque en Al.

12. Procédé selon la revendication 9; **caractérisé en ce que** les paramètres de fonctionnement du processus de pulvérisation cathodique sont réglés de telle sorte qu'il se forme un revêtement transparent imperméable au gaz en AlOₓN_{y}, sachant que 0 < x < 0,6 et 0 < y < 0,5.

13. Procédé selon la revendication 12, **caractérisé en ce que** la couche de AlOₓN_{y} présente une épaisseur de 1 à 100 nm.

14. Procédé selon la revendication 12 ou 13, **caractérisé en ce que** la couche de AlOₓN_{y} est insérée entre des couches de polymère.

15. Procédé selon la revendication 14, **caractérisé en ce que** les couches de polymère sont des couches d'acrylate d'une épaisseur comprise entre 0,2 et 1,5 µm.

16. Procédé selon la revendication 9, **caractérisé en ce que** le gaz réactif contient plus de 50 % d'azote.

17. Procédé selon la revendication 9, **caractérisé en ce que** le gaz réactif contient environ 65 % à 90 % d'azote et environ 10 % à 35 % d'oxygène.

18. Procédé.selon la revendication 14, **caractérisé en ce que** les couches de polymère sont réalisées en un matériau capable de polymérisation par voie cationique d'une épaisseur comprise entre 0,2 et 1,5 µm.
